# EUROPÄISCHE PATENTSCHRIFT

(11) **EP 0 534 924 B1**
(45) Veröffentlichungstag und Bekanntmachung des Hinweises auf die Patenterteilung: **23.04.1997**
(21) Anmeldenummer: 92890177.6
(22) Anmeldetag: 03.08.1992
(51) Int. Cl.: H03K 17/22, G01R 19/165

(54) **Dynamische Einschalt-Rücksetzschaltung**
Dynamic power-on reset circuit
Circuit dynamique de remise à zero à la mise sous tension

(30) Priorität: 01.08.1991 AT 1540/91
(43) Veröffentlichungstag der Anmeldung: 31.03.1993
(73) Patentinhaber: AUSTRIA MIKRO SYSTEME INTERNATIONAL AKTIENGESELLSCHAFT, A-8141 Unterpremstätten (AT)
(72) Erfinder: Armgarth, Dietrich, Dr. Dipl.-Ing., O-8060 Dresden (DE); Hackl, Heinz-Werner, Dipl.-Ing., A-8160 Weiz (DE)
(74) Vertreter: Haffner, Thomas M., Dr.

(56) Entgegenhaltungen:
- EP-A- 0 298 215
- WO-A-86/05933
- GB-A- 2 102 646
- PATENT ABSTRACTS OF JAPAN, Bd. 9, Nr. 131 (E-319)6. Juni 1985 & JP-A-60 018 017
- PATENT ABSTRACTS OF JAPAN, Bd. 3, Nr. 40 (E-102)6. April 1979 & JP-A-54 19 640

## Beschreibung

Die Erfindung betrifft eine dynamische Einschalt-Rücksetzschaltung, mit in Reihe geschalteten p-Kanaltransistoren zur Aufladung einer Kapazität, wobei der Drainanschluß mit dem Gateanschluß jeweils zusammengeschaltet sind.

Bei digitalen und analogen Schaltungskomplexen ist es erforderlich, nach dem Einschalten der Betriebsspannung bei allen Flip-Flops, Verknüpfungsschaltungen und analogen Schaltungskomponenten einen definierten Ausgangszustand zu erzeugen. Das ist erforderlich, um den Einschwingvorgang des Systems in möglichst kurzer Zeit zu erreichen. Der Anstieg der Versorgungsspannung liegt nun je nach Einschaltelement im µs- bis ms-Bereich. Es muß also gewährleistet sein, daß auch bei sehr schnellen Spannungsanstiegen ein genügend breiter Rücksetzimpuls erzeugt wird, um den Rücksetzvorgang aller Schaltungskomponenten abzuschließen. Weiterhin ist es erforderlich, daß beim Absinken der Betriebsspannung oder bei einem Störimpuls bis zu einer bestimmten unteren Spannungsgrenze und nach einem Wiederanstieg kein Rücksetzimpuls erzeugt wird, weil alle Flip-Flops z.B. ihren richtigen Zustand noch eingehalten haben, daß aber beim Unterschreiten eines bestimmten Grenzwertes, bei dem in der Gesamtschaltung schon labile Zustande auftreten können, unbedingt ein erneuter Rücksetzimpuls erzeugt werden muß. Außerdem sollen solche Rücksetzschaltungen im stationären Zustand keinen Arbeitsstrom benötigen, was bei CMOS-Schaltungen zwingend notwendig ist.

Bekannte Schaltungen, wie z. B. aus der EP 0303257 ("Reset signal generating circuit"), erzeugen zwar beim Anstieg der Betriebsspannung einen Rücksetzimpuls, wobei allerdings eine einstellbare Ansprechschwelle nicht vorhanden ist. Über einen p-Kanaltransistor wird hier eine Kapazität aufgeladen, die die Steuerspannung für einen n-Kanaltransistor erzeugt. Der n-Kanaltransistor entlädt nun eine zweite Kapazität und sperrt damit ein nachfolgendes Gatter.

Nachteilig ist bei dieser Schaltungsanordnung, daß zwei Kapazitäten vorhanden sein müssen, die mehr Chipfläche bedeuten und die Gesamtschaltung störanfälliger machen.

Die Schaltung gemäß der EP 0343872 ("CMOS power on-reset circuit") verwendet ebenfalls zwei Kapazitäten und drei p-Kanaltransistoren und generiert auch nur einen einmaligen Rücksetzimpuls.

Zwischen dem Gate des Feldeffekttransistors P3 und VSS sind die beiden Feldeffekttransistoren P1 und P2 angeordnet. Beide sind als Diode geschaltet, wirken als hochohmige Widerstände und sollen die Gatekapazität des Feldeffekttransistors P3 entladen.

Diese Schaltungsanordnung ist jedoch störanfällig. Bei Störimpulsen auf der Betriebsspannung VCC werden diese über C1 auf den Gateanschluß des Feldeffekttransistors P3 übertragen und verhindern so die Aufladung von C2. Das führt zur Verzögerung des gesamten Rücksetzvorganges und zur Einschränkung der Einsetzbarkeit dieser Schaltung. Eine zu hohe Spannung am Gateoxid kann außerdem zur Zerstörung des Transistors führen. Deshalb werden in MOS-Schaltungen sogenannte Gateschutzschaltungen vorgesehen.

Nach der EP 0421124 ("Power-up pulse generator circuit") wird auch wieder eine Kapazität über p-Kanaltransistoren aufgeladen, die einen Negator ansteuert, der wiederum eine zweite Kapazität entlädt. Es werden drei p-Kanal-MOS-Transistoren in Reihe geschaltet, wobei zwei davon programmiert werden können, d.h. diese Bauelemente können überbrückt werden. Auch hier kann nur ein einmaliger Rücksetzimpuls erzeugt werden.

In der EP 0155113 wird eine Schaltungsanordnung angegeben, die mit MOS-Depletion- und Enhancement-Transistoren aufgebaut ist und ebenfalls nur einen einmaligen Rücksetzimpuls erzeugt. Am Ausgang SZ wird beim Spannungsanstieg von VCC erst nach einer gewissen Zeit der VCC-Pegel erreicht. Diese Zeit, die bis dahin verstreicht, kann zum Rücksetzen verwendet werden. Für CMOS-Schaltungsanordnungen ist diese Schaltung allerdings nur bedingt geeignet.

In der EP 0171264 wird ebenfalls eine Rücksetzschaltung mit Bipolar-Transistoren vorgeschlagen, die allerdings einen relativ hohen Strombedarf aufweist.

Die Schaltungsanordnung gemäß WO 86/05933 (EP 217806) verwendet eine sperrgepolte Diode, ein Flip-Flop, einen Spannungsteiler und einen n-Kanaltransistor, um beim VDD-Anstieg einen Rücksetzimpuls am Ausgang Z zu generieren. Die sperrgepolte Diode wirkt als Kapazität und zieht beim VDD-Anstieg den Knotenpunkt A sofort auf H und damit den Knotenpunkt B auf L. Nach einer gewissen Zeit steigt das Potential am Knotenpunkt C an und setzt über den Transistor 48 den Knotenpunkt A auf L. Damit bleibt der Zustand des Flip-Flops erhalten. Erst ein Absinken von VDD auf Null und ein erneuter Anstieg generiert somit wieder einen Rücksetzimpuls. Eine bestimmte Ansprechschwelle ist nicht einstellbar.

Die Schaltung gemäß der EP 0296930 verwendet eine Kapazitätsaufladung über Dioden und erzeugt am Ausgang S ebenfalls einen gegenüber VCC verzögerten Anstieg. Während dieser Verzögerungszeit werden alle Schaltungen zurückgesetzt.

Die Schaltung nach der EP 0285033 erzeugt eine Abschaltung der Stromversorgung mit Hilfe eines externen Signals, wobei auch wieder in Reihe geschaltete p-Kanaltransistoren verwendet werden.

In der EP 0298215 wird über einen Spannungsteiler eine Kapazität langsam aufgeladen. Beim Erreichen eines bestimmten Schwellwertes innerhalb der Transistorkette wird dann diese Kapazität sprunghaft auf VCC aufgeladen. Das wird ausgenutzt, um einen Schmitt-Trigger anzusteuern, der den Rücksetzimpuls generiert.

Diese Schaltungsanordnung hat den Nachteil, daß laufend ein stationärer Strom fließt.

Die Schaltung nach der EP 0333405 verwendet einen Floating-Gate-Transistor zur Erzeugung des Rücksetzimpulses und ist daher nur in Schaltkreisen einsetzbar, die solche Transistoren verwenden.

Nachteilig ist bei allen diesen bekannten Schaltungen, daß sie nur geeignet sind, um einen einmaligen Rücksetzimpuls beim VDD-Anstieg zu generieren und oft zwei Kapazitäten benötigen, die viel Platz auf dem Chip beanspruchen. Beim Absinken der Betriebsspannung auf einen bestimmten Wert und Wiederanstieg von VDD wird auch kein erneuter Rücksetzimpuls erzeugt.

In vielen Fällen fließt auch nach dem Erzeugen des Rücksetzimpulses weiter ein stationärer Strom, der den Speicherkondensator oder die Batterie unnötigerweise belastet.

Ziel und Zweck der Erfindung ist es, eine dynamische Einschalt-Rücksetzschaltung anzugeben, die beim Anstieg von VDD von 0 auf einen Spannungsendwert generell einen Rücksetzimpuls erzeugt, die beim Absinken von VDD auf einen bestimmten Grenzwert und Wiederanstieg keinen Rücksetzimpuls erzeugt, die aber bei Unterschreitung dieses Grenzwertes und Wiederanstieg immer einen Rücksetzimpuls generiert, wobei diese Ansprechschwelle noch einstellbar sein soll, die nur eine Kapazität benötigt und die in den stationären zuständen keinen Stromverbrauch aufweist.

Zur Lösung dieser Aufgabe besteht bei einer dynamischen Einschalt-Rücksetzschaltung der eingangs genannten Art die Erfindung im wesentlichen darin, daß die Betriebsspannung mit dem Sourceanschluß eines p-Kanaltransistors und dem Sourceanschluß eines weiteren p-Kanaltransistors verbunden ist, daß der Gateanschluß und der Drainanschluß des p-Kanaltransistors sammengeschaltet und mit dem Sourceanschluß eines weiteren p-Kanaltransistors verbunden sind, daß der Gateanschluß und der Drainanschluß des p-Kanaltransistors ebenfalls miteinander verbunden und auf einen Knotenpunkt geführt sind, daß zwischen dem Knotenpunkt und Masse eine Kapazität angeordnet ist, daß der Gateanschluß des p-Kanaltransistors ebenfalls mit dem Knotenpunkt verbunden ist, daß der Drainanschluß des p-Kanaltransistors auf eine Reihenschaltung von Widerständen geführt ist, deren letzter Widerstand mit Masse verbunden ist, wobei zwischen jeweils benachbarten Widerständen der Reihenschaltung weitere Knotenpunkte vorgesehen sind, daß der Knotenpunkt zwischen den ersten beiden Widerständen der Reihenschaltung mit dem Drainanschluß eines ersten n-Kanaltransistors zusammengeschaltet ist, daß der Gateanschluß des ersten n-Kanaltransistors auf den Knotenpunkt geführt ist, daß der Sourceanschluß des ersten n-Kanaltransistors auf Masse geführt ist und daß der Knotenpunkt mit dem Ausgang zusammengeschaltet ist. Durch diese Anordnung ergibt sich insgesamt eine dynamische Einschalt-Rücksetzschaltung, die beim Einschalten der Betriebsspannung mit nahezu beliebigen Anstiegsflanken einen Rücksetzimpuls erzeugt, die eine einstellbare Ansprechschwelle aufweist und die in den stationären Zuständen keinen Strom benötigt.

Zur Einstellung der Anspruchschwelle der erfindungsgemäßen Schaltung ist die Ausbildung bevorzugt so getroffen, daß der Sourceanschluß des ersten n-Kanaltransistors mit dem Gateanschluß und dem Drainanschluß wenigstens eines zweiten n-Kanaltransistors verbunden ist, dessen Sourceanschluß auf Masse geführt ist. An Stelle des zweiten n-Kanaltransistors kann auch ein Widerstand angeordnet werden, wenn eine Ansprechschwelle zwischen 1*UTH und 2*UTH eingestellt werden soll (UTH ist die Schwellspannung der n-Kanaltransistoren). Mehrere n-Kanaltransistoren in Reihe zum zweiten n-Kanaltransistor sind erforderlich, wenn gemäß einer bevorzugten Ausbildung die Ansprechschwelle > 2*UTH eingestellt werden soll.

Weitere p-Kanaltransistoren in Reihe zu den p-Kanaltransistoren, wobei der Gate- und Drainanschluß jeweils miteinander verbunden sind, sind erforderlich, wenn auch bei langsamen Spannungsanstiegen ein Rücksetzimpuls generiert werden soll, wie dies einer bevorzugten Ausführungsform entspricht.

Desweiteren ist es vorteilhaft, den Gateanschluß eines weiteren p-Kanaltransistors mit weiteren Knotenpunkten in der Spannungsteilerkette zu verbinden, um beim Rücksetzimpulsende die Schaltung früher stromlos zu schalten.

Die Erfindung wird nachstehend an einem Ausführungsbeispiel näher erläutert, wobei die Zeichnungsfigur das elektrische Schaltbild zeigt.

In der Schaltung ist die Betriebsspannung 1 mit dem Sourceanschluß eines p-Kanaltransistors 2 und dem Sourceanschluß eines p-Kanaltransistors 7 verbunden. Gate- und Drainanschluß des p-Kanaltransistors 2 sind zusammengeschaltet und mit dem Sourceanschluß eines weiteren p-Kanaltransistors 3 verbunden. Gate- und Drainanschluß des p-Kanaltransistors 3 sind ebenfalls miteinander verbunden und auf den Knotenpunkt 5 geführt. Zwischen dem Knotenpunkt 5 und Masse 13 ist die Kapazität 4 angeordnet. Der Gateanschluß des p-Kanaltransistors 7 ist ebenfalls auf den Knotenpunkt 5 geführt. Der Drainanschluß des p-Kanaltransistors 7 ist mit einer Reihenschaltung von Widerständen 8,9,10 verbunden, wobei zwischen den Widerständen 8 und 9 der Knotenpunkt 15 und zwischen den Widerständen 9 und 10 der Knotenpunkt 14 vorgesehen und der zweite Pol des Widerstandes 10 auf Masse 13 geführt ist. Der Knotenpunkt 14 ist mit dem Ausgang 6 verbunden. Der Knotenpunkt 15 ist außerdem mit dem Drainanschluß eines n-Kanaltransistors 11 zusammengeschaltet. Der Gateanschluß dieses n-Kanaltransistors 11 ist mit dem Knotenpunkt 5 verbunden. Der Sourceanschluß des n-Kanaltransistors 11 ist mit dem Drain- und Gateanschluß eines weiteren n-Kanaltransistors 12 zusammengeschaltet. Der Sourceanschluß des n-Kanaltransistors 12 ist auf Masse 13 geführt.

Dynamisch wirkt die Schaltung folgendermaßen: Beim Anstieg der Betriebsspannung 1 in einer gewissen Zeiteinheit wird die Kapazität 4 über die p-Kanaltransistoren 2 und 3 verzögert aufgeladen. Diese p-Kanaltransistoren sind als Diode geschaltet. Unterhalb der Schwellspannung fließt nur ein sehr kleiner Strom durch diese Dioden, d. h. bis zu einem Betriebsspannungsanstieg von etwa 1,4 ... 1,5 Volt wird die Kapazität 4 nur mit einigen Nanoampere geladen. Die Spannung an der Kapazität 4 ist daher bei einer Betriebsspannung von 1,4 ... 1,5 Volt nur einige Millivolt groß, und diese Spannung am Knotenpunkt 5 steigt gegenüber der Betriebsspannung 1 verzögert weiter an. Damit wird eine Gate-Source-Spannung für den p-Kanaltransistor 7 erzeugt, die größer als die Schwellspannung dieses Transistors ist, d. h. hat die Betriebsspannung 1 einen Wert von etwa 2 Volt erreicht und ist die Spannung am Knotenpunkt 5 etwa 0,1 Volt groß, so ist diese Spannungsdifferenz größer als die Schwellspannung des p-Kanaltransistors 7. Es kann ein Strom durch den p-Kanaltransistor 7 und durch die Widerstände 8, 9 und 10 fließen. Damit entsteht an diesen Widerständen ein Spannungsabfall. Diese Spannung steigt bei gleichgroßen Widerständen von 0 auf etwa max. 1,5 Volt bei einer Betriebsspannung von 5 Volt an. Damit steht am Knotenpunkt 14 bzw. am Ausgang 6 eine Spannung zur Verfügung, die einen nachfolgenden n-Kanaltransistor sicher ansteuern kann.

Nach einer endlichen Zeit hat die Spannung am Knotenpunkt 5 auch den Wert der Betriebsspannung 1 erreicht. Die Kapazität 4 ist somit aufgeladen und UGS (Spannung zwischen Gate- und Sourceanschluß) des p-Kanaltransistors 7 ist ≈ O. Es fließt kein Strom mehr durch diesen Transistor. Der Transistor ist vollständig gesperrt. Der Stromfluß durch die Widerstände 8, 9 und 10 hört dann auf, wenn UGS ≈ UTH (UTH = Schwellspannung) ist. Bei diesem Wert wird kein Spannungsabfall an den Widerständen erzeugt.

Am Knotenpunkt 14 und damit am Ausgang 6 liegt keine Spannung an. Der nachfolgende n-Kanaltransistor ist damit sicher gesperrt. Diese Anordnung generiert also einen kurzzeitigen Spannungsimpuls am Knotenpunkt 14 und damit am Ausgang 6. Der Spannungsimpuls kann zur Triggerung eines Flip-Flops benutzt werden, um z. B. einen definierten Rücksetzimpuls zu erzeugen.

Um einen definierten Rücksetzimpuls erst unterhalb eines bestimmten Wertes der Betriebsspannung 1 zu erzeugen, ist die Anordnung der Transistoren 11 und 12 vorgesehen. Der Transistor 12 ist wieder als Diode geschaltet, d.h. am Drain- und Gateanschluß muß erst eine Spannung anliegen, die etwas größer als die Schwellspannung ist, damit durch diesen Transistor ein nennenswerter Strom fließt. Der Transistor 11 ist zwischen dem Knotenpunkt 15 und dem Transistor 12 angeordnet, wobei der Gateanschluß mit dem Knotenpunkt 5 verbunden ist. Ist die Spannung am Knotenpunkt 5 kleiner als 2∗UTH, so sind in jedem Fall die Transistoren 11 und 12 gesperrt, denn 1∗UTH ist mindestens notwendig, um den Transistor 12 zu öffnen und 1∗UTH ist zusätzlich erforderlich, um den Transistor 11 einschalten zu können.

Der Strom durch den Spannungsteiler wird in diesem Fall nicht beeinflußt. Es wird der oben beschriebene Spannungsabfall am Widerstand 10 erzeugt. Ist dagegen die Spannung am Knotenpunkt 5 auf größer gleich 2*UTH angestiegen, so werden die beiden n-Kanaltransistoren 11 und 12 leitend. Der n-Kanaltransistor 11 wird vollständig durchgesteuert. Zwischen seinem Drain- und Sourceanschluß liegt eine Spannung von etwa 100 mV im vorliegenden Fall. Am n-Kanaltransistor 12 fällt eine Spannung von etwa 0,8 ... 0,9 Volt ab. Damit nimmt die Spannung am Knotenpunkt 15 ungefähr den Wert von UTH an. Unter der Annahme, daß alle Widerstände gleich groß sind, wird sich der Spannungswert am Knotenpunkt 14 halbieren, so daß am Knotenpunkt 14 bzw. am Ausgang 6 ein Spannungswert von UTH/2 ≈ 0,35 ... 0,4 Volt auftritt.

Mit diesem Spannungswert am Ausgang 6 kann aber kein Flip-Flop mehr getriggert und auch kein n-Kanaltransistor angesteuert werden.

Diese Triggerschwelle kann nun beliebig durch Einschalten eines Widerstandes an Stelle des n-Kanaltransistors 12 oder durch zusätzliche n-Kanaltransistoren, die in Reihe mit dem n-Kanaltransistor 12 und als Diode geschaltet sind, geändert werden. Der n-Kanaltransistor 12 kann auch entfallen. Dann liegt die Triggerschwelle aber schon bei ≈ UTH.

Mit den beiden angegebenen Transistoren 11 und 12 liegt die Triggerschwelle bei etwa 1,4 ... 1,5 Volt, wenn UTH ≈ 0,7 ... 0,75 Volt ist. Damit werden auch alle Störimpulse am Ausgang 6 unwirksam, wenn der Grenzwert der Betriebsspannung von 2*UTH nicht unterschritten wird. Das bedeutet z.B., daß bei einer Betriebsspannung von 5 Volt diese erst bis auf 1,5 Volt absinken muß, damit dieser Spannungseinbruch auch am Ausgang 6 in Erscheinung tritt. Im angegebenen Beispiel wird also beim Anstieg der Betriebsspannung 1 von 0 auf z.B. 5 Volt in jedem Fall ein Rücksetzimpuls erzeugt. Sinkt die Betriebsspannung 1 im Betriebsablauf bis auf etwa 1,5 Volt ab, so wird bei einem erneuten Spannungsanstieg auf 5 Volt kein Rücksetzimpuls erzeugt. Sinkt dagegen die Betriebsspannung 1 im Betriebsablauf bis auf < 2*UTH (z.B. 1 Volt) ab, so wird bei einem erneuten Spannungsanstieg auf 5 Volt in jedem Fall auch wieder ein Rücksetzimpuls erzeugt.

Um auch bei Spannungsanstiegen im Sekundenbereich noch einen Rücksetzimpuls zu generieren, können weitere p-Kanaltransistoren in Reihe zu den p-Kanaltransistoren 2 und 3 vorgesehen werden. Die Gate- und Drainanschlüsse dieser p-Kanaltransistoren sind wieder zusammengeschaltet und wirken als Diode. Durch diese zusätzlichen p-Kanaltransistoren wird erreicht, daß der Spannungsanstieg am Knotenpunkt 5 weiter verzögert wird, so daß eine genügend große Spannungsdifferenz zwischen Source- und Gateanschluß des p-Kanaltransistors 7 auch bei den langsamen Spannungsanstiegen der Betriebsspannung 1 aufgebaut werden kann.

Weiterhin besteht die Möglichkeit, den Gateanschluß des Transistors 3 nicht mit dem Knotenpunkt 5 sondern mit dem Knotenpunkt 14 oder 15 zusammenzuschalten. Dadurch wird erreicht, daß beim Rücksetzimpulsende, wenn die Knotenpunkte Nullpotential aufweisen, der p-Kanaltransistor 3 immer voll durchgesteuert ist. Das bedeutet, daß beim Rücksetzimpulsende die Kapazität 4 schneller auf die Betriebsspannung 1 aufgeladen werden kann und daß damit nach kürzerer Zeit der Strom durch den p-Kanaltransistor 7 unterbunden wird.

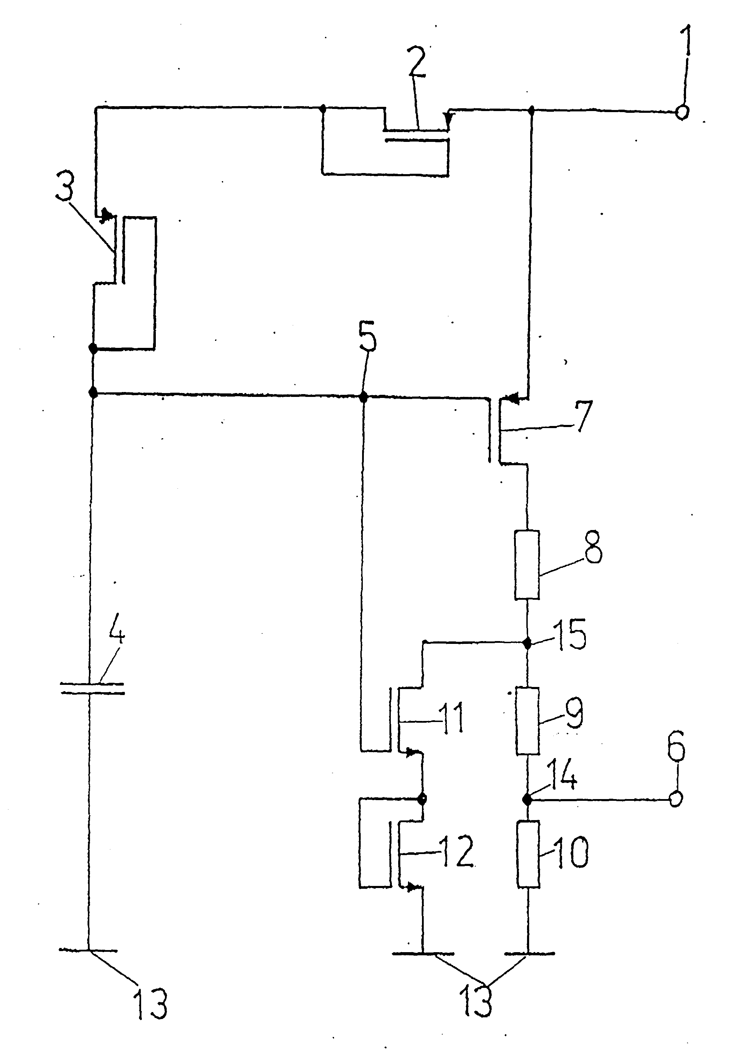

## Patentansprüche

1. Dynamische Einschalt-Rücksetzschaltung mit erstem und zweitem in Reihe geschalteten p-Kanaltransistoren (2,3) zur Aufladung einer Kapazität (4), wobei der Drainanschluß mit dem Gateanschluß jeweils zusammengeschaltet sind, dadurch gekennzeichnet, daß die Betriebsspannung (1) mit dem Sourceanschluß des ersten p-Kanaltransistors (2) und dem Sourceanschluß eines dritten p-Kanaltransistors (7) verbunden ist, daß der Gate- und der Drainanschluß des ersten p-Kanaltransistors (2) mit dem Sourceanschluß des zweiten p-Kanaltransistors (3) verbunden sind, daß der Gate- und Drainanschluß des zweiten p-Kanaltransistors (3) auf einen ersten Knotenpunkt (5) geführt sind, daß zwischen dem ersten Knotenpunkt (5) und Masse (13) die Kapazität (4) angeordnet ist, daß der Gateanschluß des dritten p-Kanaltransistors (7) ebenfalls mit dem Knotenpunkt (5) verbunden ist, daß der Drainanschluß des dritten p-Kanaltransistors (7) auf eine Reihenschaltung von einem ersten (8), einem zweiten (9) und einem dritten (10) Widerstand geführt ist, wobei der dritte Widerstand (10) mit Masse (13) verbunden ist, wobei zwischen dem ersten und dem zweiten Widerstand ein zweiter Knotenpunkt (15) vorgesehen ist, und wobei zwischen dem zweiten und dem dritten Widerstand ein dritter Knotenpunkt (14) vorgesehen ist, daß der zweite Knotenpunkt (15) mit dem Drainanschluß eines ersten n-Kanaltransistors (11) zusammengeschaltet ist, daß der Gateanschluß des ersten n-Kanaltransistors (11) auf den ersten Knotenpunkt (5) geführt ist, daß der Sourceanschluß des ersten n-Kanaltransistors (11) auf Masse (13) geführt ist und daß der dritte Knotenpunkt (14) mit dem Ausgang (6) zusammengeschaltet ist .

2. Dynamische Einschalt-Rücksetzschaltung nach Anspruch 1, dadurch gekennzeichnet, daß der Sourceanschluß des ersten n-Kanaltransistors (11) mit dem Gate- und Drainanschluß wenigstens eines zweiten n-Kanaltransistors (12) verbunden ist, dessen Sourceanschluß auf Masse (13) geführt ist.

3. Dynamische Einschalt-Rücksetzschaltung nach Anspruch 2, dadurch gekennzeichnet, daß weitere n-Kanaltransistoren in Reihe zum zweiten n-Kanaltransistor (12) vorgesehen sind.

4. Dynamische Einschalt-Rücksetzschaltung nach Anspruch 1, dadurch gekennzeichnet, daß der Sourceanschluß des ersten n-Kanaltransistors (11) über wenigstens einen weiteren Widerstand an Masse (13) geführt ist.

5. Dynamische Einschalt-Rücksetzschaltung nach einem der Ansprüche 1 bis 4, dadurch gekennzeichnet, daß weitere p-Kanal-transistoren in Reihe zu dem ersten und dem zweiten p-Kanaltransistor (2,3) geschaltet sind, wobei die Gate- und Drainanschlüsse jeweils miteinander verbunden sind.

6. Dynamische Einschalt-Rücksetzschaltung nach einem der Ansprüche 1 bis 5, dadurch gekennzeichnet, daß der Gateanschluß des zweiten p-Kanaltransistors (3) nicht mit dem ersten Knotenpunkt sondern mit entweder dem zweiten oder dem dritten Knotenpunkt zusammengeschaltet ist.

## Claims

1. A dynamic power-on reset circuit comprising a first and a second p-channel transistor (2, 3) connected in series for charging a capacitance (4), the drains and gates each being interconnected, characterized in that the operating voltage (1) is connected to the source of said first p-channel transistor (2) and to the source of a third p-channel transistor (7), that the gate and the drain of said first p-channel transistor (2) are connected to the source of the second p-channel transistor (3), that the gate and the drain of said second p-channel transistor (3) are connected to a first node (5), that the capacitance (4) is arranged between said first node (5) and mass (13), that the gate of said third p-channel transistor (7) likewise is connected to said node (5), that the drain of said third p-channel transistor (7) is connected to a series connection of a first (8), a second (9) and a third (10) resistor, said third resistor (10) being connected to mass (13), wherein a second node (15) is provided between said first and second resistors and wherein a third node (14) is provided between said second and third resistors, that said second node (15) is connected to the drain of a first n-channel transistor (11), that the gate of said first n-channel transistor (11) is connected to said first node (5), that the source of said first n-channel transistor (11) is connected to mass (13) and that said third node (14) is connected to the output (6).

2. A dynamic power-on reset circuit according to claim 1, characterized in that the source of said first n-channel transistor (11) is connected to the gate and drain of at least a second n-channel transistor (12) whose source is connected to mass (13).

3. A dynamic power-on reset circuit according to claim 2, characterized in that further n-channel transistors are provided in series with said second n-channel transistor (12).

4. A dynamic power-on reset circuit according to claim 1, characterized in that the source of said first n-channel transistor (11) is connected to mass (13) via at least one further resistor.

5. A dynamic power-on reset circuit according to any one of claims 1 to 4, characterized in that further p-channel transistors are connected in series with said first and second p-channel transistors (2, 3), the gates and drains each being interconnected.

6. A dynamic power-on reset circuit according to any one of claims 1 to 5, characterized in that the gate of said second p-channel transistor (3) is connected not to the first node, but either to the second or to the third node.

## Revendications

1. Circuit dynamique de retour à zéro au démarrage pourvu d'un premier transistor à canal p et d'un deuxième (2, 3) montés en série et destinés au chargement d'une capacité (4), dans lequel la connexion de puits est connectée avec la connexion de porte, caractérisé en ce que la tension de fonctionnement (1) est reliée à la connexion de source du premier transistor à canal p (2) et à la connexion de source d'un troisième transistor à canal p (7), en ce que les connexions de porte et de puits du premier transistor à canal p (2) sont reliées avec la connexion de source du second transistor à canal p (3), en ce que les connexions de porte et de puits du second transistor à canal p (3) sont amenées à un premier point nodal (5), en ce que la capacité (4) est disposée entre le premier point nodal (5) et la masse (13), en ce que la connexion de porte du troisième transistor à canal p (7) est également reliée au premier point nodal (5), en ce que la connexion de puits du troisième transistor à canal p (7) est amenée à un montage en série d'une première résistance (8), une seconde (9) et une troisième (10), la troisième résistance (10) étant mise à la masse (13), un second point nodal (15) étant prévu entre la première résistance et la seconde, et un troisième point nodal (14) étant prévu entre la deuxième résistance et la troisième, en ce que le second point nodal (15) est connecté avec la connexion de puits d'un premier transistor à canal n (11), en ce que la connexion de porte du premier transistor à canal n (11) est amenée au premier point nodal (5), en ce que la connexion de source du premier transistor à canal n (11) est amenée à la masse (13) et en ce que le troisième point nodal (14) est connecté avec la sortie (6).

2. Circuit dynamique de retour à zéro au démarrage selon la revendication 1, caractérisé en ce que la connexion de source du premier transistor à canal n (11) est reliée avec les connexions de porte et de puits d'au moins un deuxième transistor à canal n (12) dont la connexion de source est amenée à la masse (13).

3. Circuit dynamique de retour à zéro au démarrage selon la revendication 2, caractérisé en ce que d'autres transistors à canal n sont montés en série avec le second transistor à canal n (12).

4. Circuit dynamique de retour à zéro au démarrage selon la revendication 1, caractérisé en ce que la connexion de source du premier transistor à canal n (11) est amenée à la masse (13) en passant par au moins une autre résistance.

5. Circuit dynamique de retour à zéro au démarrage selon l'une ou l'ensemble des revendications 1 à 4, caractérisé en ce que d'autres transistors à canal p sont montés en série avec le premier transistor à canal p et le second (2, 3), les connexions de porte et de puits étant reliées entre elles.

6. Circuit dynamique de retour à zéro au démarrage selon l'une ou l'ensemble des revendications 1 à 5, caractérisé en ce que la connexion de porte du second transistor à canal p (3) n'est pas connectée au premier point nodal mais soit au deuxième point nodal, soit au troisième.
